# DEMANDE DE BREVET EUROPEEN

(11) **EP 4 528 387 A1**
(43) Date de publication de la demande: **26.03.2025**
(21) Numéro de dépôt: 24200890.2
(22) Date de dépôt: 17.09.2024
(51) Int. Cl.: G04B 1/14, B81C 99/00, G04B 13/02, G04B 15/14, G04B 17/06, G04B 19/04

(54) **PROCÉDÉ DE FABRICATION DE COMPOSANTS HORLOGERS EN SILICIUM**

(30) Priorité: 20.09.2023 CH 10332023
(71) Demandeur: Richemont International S.A., 1752 Villars-sur-Glâne (CH)
(72) Inventeur: CHABART, Mickaël, 2014 Fleurier (CH)
(74) Mandataire: Novagraaf International SA

(57) **Abrégé**

Un procédé de fabrication d'une pluralité de composants horlogers (90) présentant des surfaces flancs (95) dans une plaquette de fabrication de type SOI (10) est décrit. La plaquette SOI (10) comprend une couche de support (20) en silicium, une couche de travail (30) en silicium, et une couche d'oxyde enterrée (40) en oxyde de silicium séparant la couche de support (20) de la couche de travail (30). Le procédé comprend les étapes de : (a) former les composants horlogers (90) en gravant des motifs dans la couche de travail (30) ; (b) oxyder thermiquement la plaquette SOI (10) afin de former une couche d'oxyde (55) sur les surfaces flancs (95) des composants horlogers (90) gravées dans la couche de travail (30) ; et (c) éliminer, en une seule étape, la couche d'oxyde (55) sur les surfaces flancs (95) des composants horlogers (90) ainsi qu'au moins une partie de la couche d'oxyde enterrée (40) de la plaquette SOI (10) en dessous des composants horlogers (90) afin de lisser lesdites surfaces flancs (95) et afin de libérer les composants horlogers (90) de ou dans la plaquette SOI (10), les composants horlogers (90) libérés n'étant supportés structurellement que par des ponts de liaison (35) dans la couche de travail (30). Lors de la libération des composants horlogers 90, soit toute la couche de travail 30 soit une partie 30A de cette couche de travail 30 comprenant tous ou un sous-ensemble des composants horlogers 90, est séparée du reste de la plaquette SOI 10 et notamment de la couche de support 20.

## Description

### Domaine technique

L'invention concerne un procédé de fabrication de composants horlogers en silicium sur une plaquette de type « silicon-on-insulator » (SOI), une telle plaquette comprenant une couche de support en silicium, une couche de travail en silicium dans laquelle les composants sont fabriqués, et une couche d'oxyde de silicium séparant ces deux couches. Un tel procédé de fabrication comprend généralement des étapes de microfabrication incluant la lithographie et la gravure sèche des couches de la plaquette ainsi que des étapes de fabrication postérieures à la gravure incluant la libération des composants et le lissage des surfaces gravées.

### Etat de la technique

La fabrication de composants horlogers en silicium tels que, mais de façon non limitative, des ressorts spiraux, des cames, des ressorts, des cliquets, des roues et des ancres en utilisant des procédés de microfabrication est bien connue. Avantageusement, plusieurs centaines de composants horlogers peuvent être fabriqués sur une seule plaquette (en anglais « wafer ») en utilisant ces technologies. Il est, par exemple, connu de réaliser une pluralité de résonateurs en silicium avec une très haute précision en utilisant des procédés de photolithographie et d'usinage gravure dans une plaquette en silicium. Les procédés de réalisation de ces composants horlogers utilisent généralement des plaquettes de silicium monocristallin, mais des plaquettes en silicium polycristallin ou amorphe sont également utilisables.

Le silicium est un matériau diamagnétique, et son utilisation pour la fabrication de composants horlogers, et notamment pour les composants de l'organe régulateur d'un mouvement de montre mécanique, est avantageuse car aucun effet rémanent n'est observé après l'exposition de ce matériau aux champs magnétiques. De plus, les variations du module d'Young d'un composant horloger en silicium en fonction de la température peuvent être compensées par l'ajout d'une couche d'oxyde sur le composant. Quand les composants horlogers sont réalisés à partir d'une plaquette en silicium monocristallin, l'une quelconque des trois orientations cristallines <100>, <110> ou <111> peut être utilisée.

Les plaquettes de silicium sont proposées sous forme de galette simple, par exemple des wafers de type SSP (« Single Side polished » en anglais) ou de type DSP (« Dual Side Polished » en anglais). Cependant, ce sont les plaquettes SOI (« silicon-on-insulator » en anglais) qui sont le plus souvent utilisées pour la fabrication de composants horlogers. Une plaquette SOI comprend une couche de travail en silicium (la couche « device » en anglais) dans laquelle les composants horlogers sont fabriqués, une couche de support en silicium qui sert de substrat ou de support lors de la fabrication des composants (la couche « handle » en anglais), et une couche d'oxyde de silicium enterrée qui se trouve entre les deux couches de silicium (la couche « buried oxide layer » ou BOX en anglais). La surface de la couche de travail et éventuellement la surface de la couche de support peuvent également être polies pour faciliter des étapes de lithographie sur ces couches.

Après les étapes de lithographie et de gravure pour initialement former les composants horlogers dans la couche de travail, ces derniers sont normalement libérés de la couche de support et de la couche d'oxyde enterrée de la plaquette SOI afin de faciliter des étapes de fabrication subséquentes. De cette manière, après la libération, les composants horlogers ne sont supportés structurellement que par des ponts de liaison fins qui les maintiennent attachés aux parties subsistantes de la couche de travail, ce qui permet notamment d'effectuer les étapes de fabrication subséquentes sur l'ensemble de la surface externe des composants de la plaquette. Les étapes subséquentes peuvent notamment comprendre des étapes d'oxydation et désoxydation pour le lissage des surfaces des composants. Les étapes subséquentes peuvent également comprendre des étapes d'oxydation et désoxydation pour ajuster les dimensions des composants (par exemple afin de corriger la raideur quand les composants sont des spiraux ou des résonateurs) et/ou des étapes d'oxydation pour former une couche externe d'oxyde de silicium sur les composants aux fins d'une compensation thermique et/ou d'un renforcement mécanique.

La libération des composants horlogers sur une plaquette SOI peut être réalisée par différentes méthodes. Selon une approche décrite dans le document WO2019180596, après la formation des composants, la couche de travail (ou une partie de cette couche comprenant les composants) est séparée de la couche de support. Cette séparation peut être facilitée par la gravure d'une saignée entourant les composants ainsi que des ouvertures dans la couche de travail. Par la suite, la couche d'oxyde enterrée est gravée avec de la vapeur d'acide hydrofluorique (HF) qui passe au travers des ouvertures dans la couche de travail, et la partie de la couche de travail définie par la saignée est séparée de la couche de support de la plaquette SOI.

La libération des composants horlogers sur une plaquette SOI peut être réalisée également par une approche de type « back side » telle que décrite dans les documents de brevet JP2017219520 et WO2019180177. Selon cette approche, après la formation des composants par gravure, on fait croître une couche d'oxyde qui sert de protection pour les composants formés. Par la suite, on réalise une photolithographie et une gravure pour exposer le silicium de la couche de support et graver la couche de support en l'attaquant par la face opposée aux composants, ce qui enlève la couche de support en dessous des composants. Pour terminer la libération selon cette alternative, on élimine la couche enterrée de la plaquette SOI en dessous des composants (qui est complètement exposée depuis le côté arrière après l'élimination de la couche de support) ainsi que la couche de protection sur les composants. Cette approche de libération « back side » est cependant relativement longue et coûteuse, car elle exige une structuration (voire une photolithographie et une gravure) au travers de la couche de support épaisse de la plaquette SOI.

De manière générale, la fabrication de composants horlogers en silicium comprend un nombre important d'étapes, et il serait alors désirable d'avoir un procédé de fabrication de composants ayant un nombre d'étapes réduit.

### Bref résumé de l'invention

Un but de la présente invention est de proposer un procédé de fabrication d'une pluralité de composants horlogers sur une plaquette SOI, qui permet d'éviter ou de pallier les inconvénients ci-dessus, ou en tout cas d'offrir un meilleur compromis entre ces inconvénients.

En particulier, ce but est au moins partiellement atteint en proposant un nouveau procédé de fabrication selon lequel la même étape de désoxydation d'une plaquette SOI - voire la même étape d'élimination des couches d'oxydes sur la plaquette SOI - permet de réaliser à la fois un lissage de surfaces flancs (des surfaces latérales des composants horlogers, c'est-à-dire les surfaces des composants horlogers qui sont généralement normales au plan général de la plaquette) gravées des composants horlogers et une libération de ces composants dans ou de la plaquette SOI. Ainsi, selon un aspect, la présente invention concerne un procédé de fabrication d'une pluralité de composants horlogers présentant des surfaces flancs dans une plaquette de fabrication de type SOI, la plaquette SOI comprenant une couche de support en silicium, une couche de travail en silicium, et une couche d'oxyde enterrée en oxyde de silicium séparant la couche de support de la couche de travail. Le procédé comprend les étapes de : (a) former les composants horlogers en gravant des motifs dans la couche de travail; (b) oxyder thermiquement la plaquette SOI afin de former une couche d'oxyde sur au moins une partie des surfaces flancs (c'est-à-dire qu'on forme une couche d'oxyde sur au moins une partie de chaque surface flanc, ou sur au moins une partie des surfaces flancs) des composants horlogers gravés dans la couche de travail; et (c) éliminer, en une seule étape, la couche d'oxyde sur les surfaces flancs des composants horlogers ainsi qu'au moins une partie de la couche d'oxyde enterrée de la plaquette SOI en dessous des composants horlogers afin de lisser lesdites surfaces flancs et afin de libérer les composants horlogers de ou dans la plaquette SOI les composants horlogers libérés n'étant supportés structurellement que par des ponts de liaison dans la couche de travail. Préférentiellement, l'étape (b) consiste à oxyder thermiquement la plaquette SOI afin de former une couche d'oxyde sur les surfaces flancs (de préférence afin de former une couche d'oxyde sur toutes les surfaces flancs) des composants horlogers gravés dans la couche de travail. Lors de la libération des composants horlogers, soit toute la couche de travail soit une partie de cette couche de travail comprenant tous ou un sous-ensemble des composants horlogers, est séparée du reste de la plaquette SOI et notamment de la couche de support. Cette dernière peut rester donc intacte, permettant une libération simple et économique.

Le procédé peut être défini par les caractéristiques suivantes, prises individuellement ou en combinaison.

Avantageusement, lors la désoxydation effectuée à l'étape (c), on réalise non seulement un lissage des surfaces flancs des composants horlogers sur la plaquette mais en même temps la libération simple et efficace de ces composants de la plaquette SOI. En réalisant le lissage et la libération avec une seule étape de désoxydation, le nombre d'étapes dans le procédé de fabrication des composants horlogers dans la plaquette SOI est favorablement réduit.

De préférence, en formant les composants horlogers à l'étape (a), on grave les motifs par une technique de gravure ionique réactive profonde. De plus, cette étape (a) de former les composants horlogers peut comprendre la formation d'une couche d'oxyde structurée sur la surface supérieure de la couche de travail avant la gravure, et dans ce cas l'étape (c) comprend également l'élimination de cette couche d'oxyde structurée.

Par ailleurs le procédé peut comprendre une étape de formation de trous de libération dans la couche de travail et/ou de formation d'une tranchée de libération dans la couche de travail. Cette tranchée de libération peut notamment définir le périmètre d'une partie de la couche de travail qui sera libérée.

Selon un mode de réalisation, les trous de libération sont formés dans des zones de la couche de travail agencées à l'écart des zones réservées à la gravure des composants horlogers. Selon cette mise en oeuvre, les trous de libération étant formés à l'écart des zones réservées aux composants horlogers, les trous de libération (leur forme, leur nombre, leurs dimensions...) n'ont aucune influence sur les composants horlogers et leur design. Selon une mise en oeuvre, les trous de libération peuvent être de formes et/ou de dimensions différentes les uns des autres, sur une même plaquette.

Selon un mode de réalisation, les trous de libération s'étendent sur toute l'épaisseur de la couche de travail afin d'exposer la couche d'oxyde enterrée en dessous. Selon cette mise en oeuvre, les trous de libération permettent d'exposer la couche d'oxyde enterrée directement depuis la face supérieure de la couche de travail.

Selon un mode de réalisation, les trous de libération sont distribués sur les parties subsistantes de la partie de la couche de travail qui sera libérée incluant des parties subsistantes qui se trouvent entre des composants horlogers. On peut prévoir une répartition régulière qui permet d'exposer et de supprimer la couche d'oxyde enterrée de manière rapide et homogène.

Selon un mode de réalisation, la tranchée de libération s'étend sur toute l'épaisseur de la couche de travail afin d'exposer la couche d'oxyde enterrée en dessous.

Selon un mode de réalisation, le procédé est exempt de gravure de la couche de support effectuée depuis la face inférieure de la couche de support et débouchant dans la couche enterrée. Selon un mode de réalisation, après la libération des composants horlogers à l'étape (c), la couche de support est toujours intacte. Autrement dit, le procédé ne fait pas appel à une libération du type « back side ».

Selon un mode de réalisation, l'élimination de la couche d'oxyde enterrée est effectuée au moins en partie dans une zone agencée entre la couche de travail et la couche de support. Autrement dit, l'élimination de la couche d'oxyde enterrée est effectuée pour supprimer un lien mécanique ou une liaison (la couche d'oxyde enterrée) entre une partie subsistante de la couche de travail et la couche de support. Selon ce mode de réalisation, l'élimination de la couche d'oxyde enterrée comprend la formation d'un front de gravure de la couche d'oxyde enterrée qui progresse, au moins à un moment donné, entre une partie subsistante de la couche de travail et la couche de support.

D'autres caractéristiques avantageuses et privilégiées du procédé de fabrication sont précisées dans la description et les sous-revendications ci-dessous.

### Brève description des figures

Des exemples de mise en oeuvre de l'invention sont indiqués dans la description illustrée par les figures annexées dans lesquelles :
- Les figures 1a-1j illustrent schématiquement une série d'étapes de fabrication d'un composant horloger dans une plaquette SOI selon un mode de réalisation ; et
- La figure 2 est une vue de dessus de la couche de travail d'une plaquette SOI après les étapes de la figure 1 selon un mode de réalisation.

### Exemples de mode de réalisation de l'invention

Dans tout ce qui suit, les orientations sont les orientations des figures. En particulier, les termes comme « supérieur », « inférieur », « gauche », « droit », « dessus », « dessous », « vers l'avant » et « vers l'arrière » s'entendent généralement par rapport au sens de représentation des figures. Les figures sont schématiques et peuvent présenter des proportions et/ou des aspects différents de la réalité même au sein d'une même figure, mais illustrent à tout le moins le déroulement et/ou les étapes des procédés décrits.

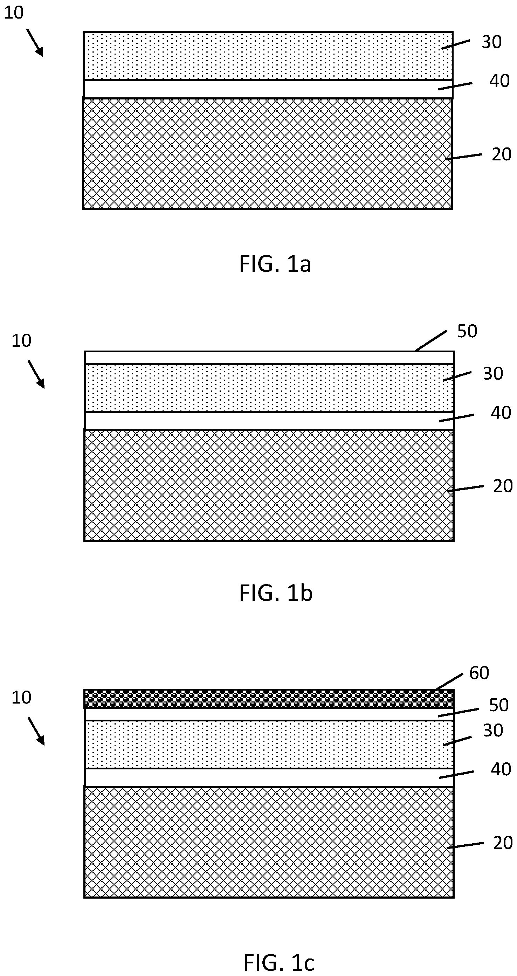

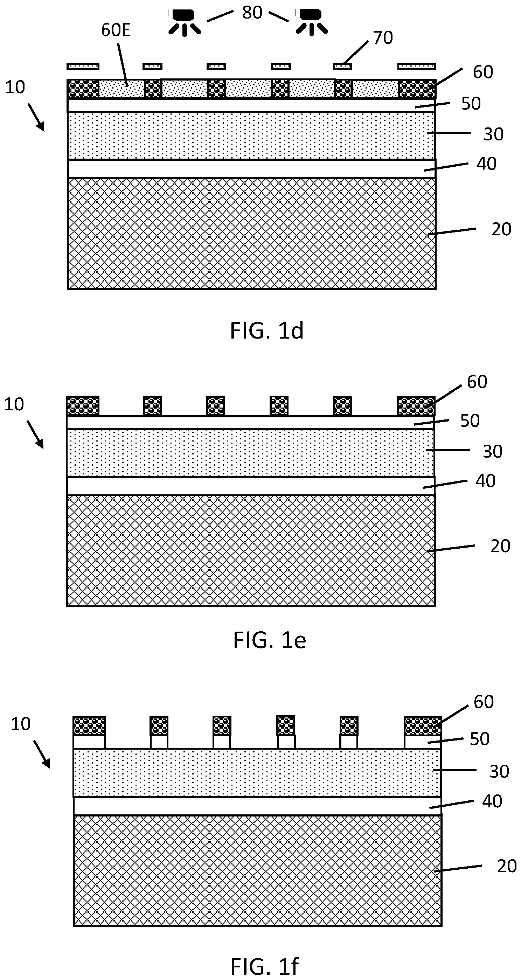

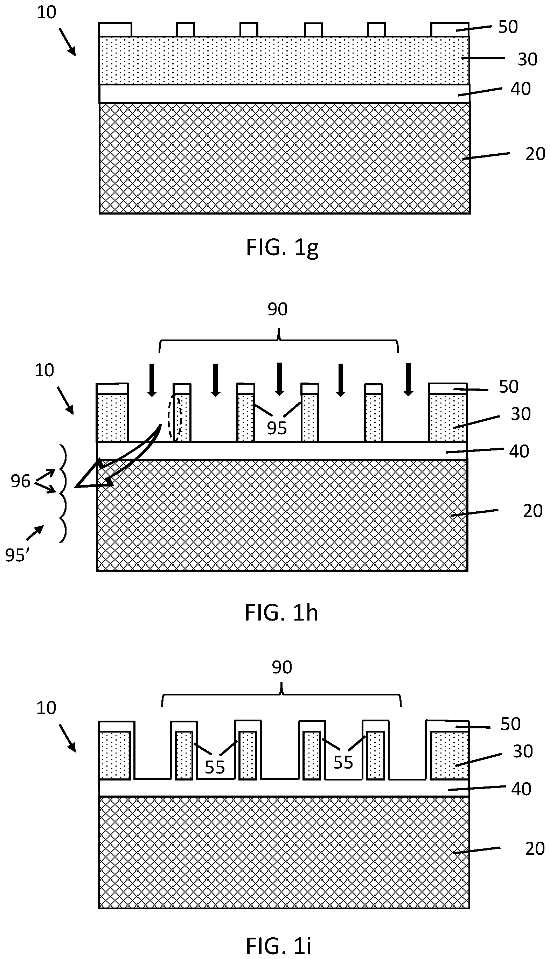

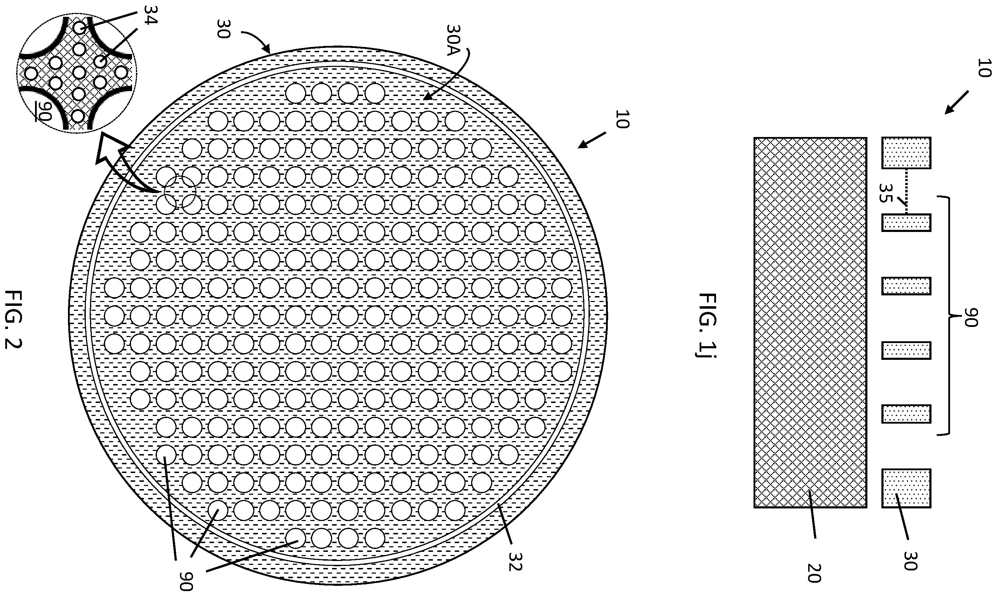

Les figures 1a-1j illustrent une série d'étapes de fabrication schématiques d'un composant horloger dans une plaquette SOI 10 selon un mode de réalisation de l'invention. Bien entendu, plusieurs composants horlogers peuvent être fabriqués dans la plaquette 10 en même temps, mais les vues de la figure 1 sont isolées sur un seul composant pour simplicité. Le procédé commence avec une plaquette SOI 10 illustrée à la figure 1a, cette plaquette comprenant une couche de support 20 en silicium, une couche de travail 30 en silicium, et une couche d'oxyde enterrée 40 séparant les deux couches de silicium 20, 30 qui est notamment en oxyde de silicium (SiO₂). Le dessin n'est pas à l'échelle, mais à titre d'exemple, la couche de support 20 peut avoir une épaisseur de 500 µm, la couche de travail 30 peut avoir une épaisseur de 120 µm, et la couche d'oxyde enterrée 40 peut avoir une épaisseur de 2 µm. Les couches de support et de travail peuvent être du même type de silicium ou de types différents - par exemple de silicium monocristallin avec une orientation cristalline quelconque, du silicium polycristallin, ou du silicium amorphe. Les couches de silicium 20, 30 et notamment la couche de travail 30 peuvent être dopés type N ou type P. Par exemple, l'utilisation d'un silicium fortement dopé peut être avantageuse pour la fabrication des résonateurs car, par exemple, on constate une déformation moindre de la matière dopée lors de l'oxydation thermique sous certaines conditions.

Dans la figure 1b, une étape de lithographie commence avec la formation d'une couche d'oxyde de silicium 50 sur la surface supérieure de la couche de travail 30. Par « lithographie », on entend l'ensemble des opérations permettant de transférer une image ou un motif sur ou au-dessus de la plaquette 10 vers cette dernière. La couche d'oxyde 50 peut par exemple avoir une épaisseur comprise entre 0.4 - 6 µm, et elle peut être formée par oxydation thermique ou alternativement par un dépôt de type PVD, CVD, ou ALD. Si la couche d'oxyde 50 est formée par un procédé de dépôt directionnel tel que le CVD ou le PVD, l'oxyde se forme uniquement sur la surface supérieure de la couche de support, tel qu'illustré à la figure 1b. Alternativement, si la couche d'oxyde 50 est formée par oxydation thermique, on remarque que l'oxyde 50 peut se former généralement en même temps sur la surface de la couche de support 20 (si cette dernière n'est pas couverte par un masque d'épargne) ou encore un second dépôt directionnel de type CVD ou PVD peut être effectué sur la surface de la couche de support 20. De manière générale, la formation de la couche d'oxyde 50 avant le dépôt d'une couche de résine (voir la figure 1c) permet de déposer une couche de résine relativement fine et uniforme avec une bonne homogénéité de surface et ainsi d'optimiser la gravure subséquente de motifs fins et profonds dans la couche de travail 30. Cependant, dans d'autres modes de réalisation, il est également possible de réaliser une étape de lithographie sans la couche d'oxyde, notamment en utilisant une résine photosensible plus épaisse.

A la figure 1c, la couche d'oxyde 50 est recouverte d'une couche de résine 60, qui est typiquement une résine photosensible de type positif ou négatif. Cette couche de résine peut avoir une épaisseur comprise entre 0.5 - 12 µm, à titre purement illustratif. Par la suite, dans la figure 1d, la couche de résine 60 est structurée de préférence en utilisant une étape de photolithographie avec une source de lumière ultraviolette 80 ainsi que, par exemple, un masque d'exposition 70 tel qu'un photomasque. Un système de stepper et réticule peut également être utilisé pour l'étape de photolithographie. Dans l'exemple illustré, la couche 60 comprend une résine photosensible de type positif dont les parties 60E de la résine qui sont exposées à la lumière deviennent solubles dans un révélateur et les parties non exposées restent insolubles. Selon d'autres modes de réalisation, la résine peut être structurée par un faisceau laser ou d'électrons.

Dans la figure 1e, la couche de résine 60 est ouverte après avoir été développée par un révélateur, notamment un solvant qui élimine les parties exposées 60E de la résine par voie chimique. Ensuite, à la figure 1f, les parties de la couche oxyde 50 qui se trouvaient en dessous des parties exposées 60E de la résine sont aussi retirées de la surface de la couche de travail 30, par exemple en employant une gravure plasma sélective avec les gaz CH₄/O₂. L'utilisation d'une technique de gravure directionnelle est généralement privilégiée lors de cette étape car elle est plus précise, mais alternativement une gravure à base de vapeur d'acide hydrofluorique (HF) peut aussi être utilisée.

A l'étape illustrée à la figure 1g, la partie restante de la couche de résine 60 est éliminée et ensuite, à l'étape de la figure 1h, des motifs sont gravés dans la couche de travail 30 au travers de la couche 50 structurée pour former le composant horloger 90. En général, les motifs gravés s'étendent sur toute l'épaisseur de la couche de travail 30 tel qu'illustré, et à cette fin la couche d'oxyde enterrée 40 peut agir comme un stop lors de la gravure. De cette manière, l'épaisseur des composants horlogers 90 correspond à l'épaisseur de la couche de travail 30.

La gravure à l'étape de la figure 1h peut notamment être effectuée par une technique de gravure ionique réactive profonde (également connue sous l'acronyme DRIE pour « Deep Reactive Ion Etching » en anglais). La gravure DRIE permet d'usiner des trous et des tranchées profondes dans la couche 30 avec un rapport largeur/hauteur important, ce qui est bien adapté pour des composants micromécaniques comme des composants horlogers. Alternativement, la structuration de la couche de support peut être réalisée par d'autres technologies de gravure telles qu'une opération de gravure humide/chimique anisotrope, par exemple en utilisant un bain d'hydroxyde de potassium (KOH) ou d'hydroxyde de tétraméthylammonium (TMAH). Une structuration par gravure humide/chimique peut notamment être plus rapide qu'une gravure ionique réactive profonde, mais la résolution dimensionnelle des structures gravées est généralement moins bonne. Si une opération de gravure humide/chimique anisotrope est employée, la couche d'oxyde 50 n'est normalement pas formée sur la surface supérieure de la couche de support 20 avant le dépôt de la résine 60 sur cette surface.

Il est également possible pour la partie restante de la couche de résine 60 d'être toujours présente lors de l'étape de gravure (DRIE ou autre) de la couche de travail 30. Cette partie restante de la couche de résine peut être retirée après la gravure, et dans ce cas la couche de travail 30 est gravée au travers des deux couches 50, 60 structurées (ou seulement à travers la couche 60 structurée si une couche oxyde 50 n'est pas présente). A titre d'exemple, une résine positive peut être retirée par des solvants de type acétone ou diméthylsulfoxyde (DMSO) ou avec un plasma O₂ soit avant soit après l'étape de gravure. Pour une résine négative comme le SU-8, un plasma CF₄/O₂ peut être employé pour son retrait.

Après l'étape de gravure de la couche de travail pour former les composants horlogers 90, il est connu que les surfaces flancs 95 des motifs structurés des composants 90 possèdent une rugosité relativement importante. Dans le cadre d'une gravure type DRIE, cette rugosité se manifeste en forme d'une surface 95' avec des ondulations souvent appelées « scallops » avec des pics 96 comme illustré à la partie gauche de la figure 1h. En fait, lors d'une gravure DRIE on alterne entre une phase de gravure du silicium et une phase de passivation ce qui résulte en la surface ondulée 95'. Après une gravure DRIE ou un autre type de gravure, la rugosité des surfaces 95 peut être réduite par une étape de lissage, ce qui renforce ces surfaces mécaniquement en limitant les amorces de rupture. Ce lissage peut notamment être effectué par une étape d'oxydation thermique suivie par une étape de désoxydation, constituée par exemple d'une gravure par voie humide ou en phase vapeur à base d'acide fluorhydrique (HF). De manière connue, lors de l'oxydation thermique, le silicium à la surface 95 est consommée, et cette consommation est généralement plus rapide vers les pics 96, ce qui résulte en une surface de silicium plus lisse après la désoxydation.

Selon l'invention, contrairement aux procédés de fabrication de l'art antérieur où le lissage est effectué après la libération des composants horlogers 90, à la figure 1i les surfaces flancs 95 du composant 90 sont oxydées thermiquement avant la libération des composants sur la plaquette 10. Cette étape d'oxydation, qui a lieu typiquement dans un four, forment une couche d'oxyde 55 (notamment de SiO₂) sur les surfaces flancs 95 du composant. L'épaisseur de cette couche d'oxyde 55 peut varier mais de préférence elle est au moins 0.05 µm. Par ailleurs, la couche d'oxyde 55 rejoignent les couches d'oxydes 50 et 40 déjà présentes sur les surfaces supérieure et inférieure du composant 90, et ces dernières couches peuvent aussi devenir plus épaisses lors de l'oxydation de cette étape. Selon une variante, la couche d'oxyde 50 peut être éliminée après l'étape de gravure à la figure 1h, et dans ce cas la couche d'oxyde 55 se forme également sur la surface supérieure des composants horlogers 90 lors de cette étape d'oxydation.

Par la suite, à la figure 1j, on effectue une désoxydation pour éliminer les couches d'oxydes 40, 50 et 55 autour du composant 90. Cette étape de désoxydation est de préférence réalisée par une gravure par voie humide ou en phase vapeur à base d'acide fluorhydrique (HF).

Avantageusement, lors de cette étape de désoxydation, on réalise non seulement un lissage des surfaces flancs 95 des composants horlogers 90 sur la plaquette 10 mais en même temps la libération de ces composants dans ou de la plaquette SOI. Comme décrit ci-dessus, le but de la libération est de permettre la réalisation des étapes de fabrication subséquentes sur la quasi-totalité de la surface externe des composants de la plaquette. A cette fin, après la libération, les composants horlogers ne sont supportés structurellement que par des ponts de liaison (illustré schématiquement en trait à 35 dans la figure 1j; en réalité le pont s'étend sur toute la hauteur du composant) dans la couche de travail afin que les composants 90 restent attachés aux parties subsistantes de cette couche. En réalisant le lissage et la libération avec une seule étape de désoxydation selon la présente invention, le nombre d'étapes dans le procédé de fabrication des composants horlogers 90 dans la plaquette SOI est favorablement réduit.

Selon l'invention, lors de la libération des composants 90, soit toute la couche de travail 30 soit une partie de cette couche comprenant tous ou un sous-ensemble des composants horlogers 90, est séparée du reste de la plaquette SOI et notamment de la couche de support 20. Comme illustré à la figure 1j, après la libération des composants horlogers, la couche de support 20 est toujours intacte. Il n'y a donc aucun besoin de structurer la couche de support épaisse (par une photolithographie et une gravure) pour réaliser la libération des composants, contrairement à l'approche de libération de type « back side » de l'art antérieur qui est longue et coûteuse. La figure 2 est une vue de dessus de la couche de travail 30 de la plaquette SOI 10 après les étapes de fabrication des figures 1a-1j selon un mode de réalisation. A noter que dans la figure 2 les composants horlogers 90 se trouvent dans des zones de la couche qui sont simplement illustrés par des cercles vides afin de ne pas surcharger le dessin. Dans ce mode réalisation, une partie 30A de la couche de travail 30 comprenant les composants horlogers 90, est séparée du reste de la plaquette SOI lors de la libération. Pour faciliter cette séparation, une tranchée de libération 32 et des trous de libération 34 sont formées dans la couche de travail 30 lors de la formation des composants horlogers. Comme les motifs gravés qui forment les composants horlogers 90, la tranchée 32 et les trous 34 s'étendent sur toute l'épaisseur de la couche de travail 30 afin d'exposer la couche d'oxyde enterrée 40 en sous. La tranchée 32 peut notamment définir le périmètre de la partie 30A libérée de la couche de travail. Dans l'exemple de la figure 2, la tranchée 32 est circulaire, mais elle peut avoir d'autres formes, telle qu'une forme rectiligne. Les trous de libération 34 sont de préférence distribuées sur les parties subsistantes de la partie 30A de la couche de travail, comme illustré dans la vue magnifiée de la figure, incluant des parties subsistantes de la partie 30A de la couche de travail qui se trouvent entre des composants horlogers 90. Lors de la désoxydation à l'étape de la figure 1j, la tranchée de libération 32 et les trous de libération 34 permet à un agent de gravure (tel que l'acide fluorhydrique (HF)) d'attaquer plus rapidement la couche d'oxyde enterrée 40 en dessous de la partie 30A (l'agent de gravure attaquant déjà la couche 40 par les trous dans la structure des composants horlogers) afin que cette partie de la couche enterrée peut être complètement éliminée, permettant ainsi la séparation de la partie 30A de la couche de travail du reste de la plaquette SOI 10. La tranchée de libération 32 et les trous de libération 34 facilitent donc la libération en accélérant la gravure de la couche d'oxyde enterrée 40 tout en réduisant la période durant laquelle les composants horlogers 90 sont en contact avec l'agent de gravure.

Après la libération des composants horlogers 90, si souhaité, une autre étape d'oxydation thermique suivie par une étape de désoxydation peuvent être réalisées pour effectuer un lissage au moins une nouvelle fois. D'autres étapes de fabrication subséquentes au lissage et à la libération peuvent aussi être effectuées. Par exemple, on peut effectuer une autre étape d'oxydation suive par une désoxydation pour ajuster les dimensions des composants, ou on peut former une couche d'oxyde de silicium (SiO₂) permanente sur au moins une partie de toute la surface externe des composants horlogers 90. Dans le cadre d'un spiral ou d'un autre type de résonateur horloger, une telle couche d'oxyde permanente compense les variations du module d'Young de l'âme en silicium du composant horloger en fonction de la température. Par ailleurs, la formation d'une telle couche externe d'oxyde de silicium sur les composants horlogers de n'importe quel type peut également servir à renforcer ces composants mécaniquement. D'autres types de matériaux peuvent également être formés sur les composants horlogers 90, par exemple par un dépôt type ALD. Il est également possible d'effectuer une étape de pré-assemblage ou d'usinage des composants horlogers 90 lorsqu'ils sont toujours attachés à la plaquette SOI 10 et/ou à la couche de travail libérée 30,30A, comme par exemple pour assembler le composant à un axe, un tigeron, un piton ou une virole.

Les différentes étapes d'oxydation mentionnées ci-dessus peuvent être réalisées en plaçant la plaquette SOI ou la partie libérée 30A de la couche de travail dans un four à une température comprise entre 800°C et 1200°C et dans une atmosphère oxydante comprenant par exemple la vapeur d'eau ou du gaz de dioxygène (O₂). L'épaisseur de la couche d'oxyde formée dépend de manière connue de la durée de l'étape d'oxydation.

Une fois que les étapes de fabrication des composants horlogers 90 sur la plaquette SOI 10 et/ou la couche de travail libérée 30,30A sont complétées, les composants horlogers peuvent être détachés individuellement et par la suite assemblé et monté chacun dans une pièce d'horlogerie, par exemple dans un oscillateur ou dans un mécanisme d'échappement d'un mouvement horloger mécanique.

La présente invention n'est pas limitée aux modes de réalisation et variantes présentés et d'autres modes de réalisation et variantes apparaîtront clairement à l'homme du métier. Ainsi, les réalisations ci-dessus sont des exemples. Bien que la description se réfère à un ou plusieurs modes de réalisation et leurs variantes, ceci ne signifie pas nécessairement que chaque référence concerne le même mode de réalisation ou variante, ou que les caractéristiques s'appliquent seulement à un seul mode de réalisation ou variante. De simples caractéristiques de différents modes de réalisation et leurs variantes peuvent également être combinées et/ou interchangées pour fournir d'autres réalisations.

## Revendications

1. Procédé de fabrication d'une pluralité de composants horlogers (90) présentant des surfaces flancs (95) dans une plaquette de fabrication de type SOI (10), la plaquette SOI (10) comprenant une couche de support (20) en silicium, une couche de travail (30) en silicium, et une couche d'oxyde enterrée (40) en oxyde de silicium séparant la couche de support (20) de la couche de travail (30), le procédé comprenant les étapes suivantes :
(a) former les composants horlogers (90) en gravant des motifs dans la couche de travail (30) ;
(b) oxyder thermiquement la plaquette SOI (10) afin de former une couche d'oxyde (55) sur les surfaces flancs (95) des composants horlogers (90) gravés dans la couche de travail (30) ; et
(c) éliminer, en une seule étape, la couche d'oxyde (55) sur les surfaces flancs (95) des composants horlogers (90) ainsi qu'au moins une partie de la couche d'oxyde enterrée (40) de la plaquette SOI (10) en dessous des composants horlogers (90) afin de lisser lesdites surfaces flancs (95) et afin de libérer les composants horlogers (90) de ou dans la plaquette SOI (10), les composants horlogers (90) libérés n'étant supportés structurellement que par des ponts de liaison (35) dans la couche de travail (30) ;
**caractérisé en ce que** lors de la libération des composants horlogers (90) soit toute la couche de travail (30) soit une partie (30A) de cette couche de travail (30) comprenant tous ou un sous-ensemble des composants horlogers (90) est séparée du reste de la plaquette SOI (10) et notamment de la couche de support (20).

2. Procédé selon la revendication précédente, dans lequel en formant les composants horlogers (90) à l'étape (a), on grave les motifs par une technique de gravure ionique réactive profonde.

3. Procédé selon l'une des revendications précédentes, dans lequel l'étape (a) de former les composants horlogers (90) comprend la formation d'une couche d'oxyde (50) structurée sur la surface supérieure de la couche de travail (30) avant la gravure, et dans lequel l'étape (c) comprend également l'élimination de la couche d'oxyde (50) structurée sur la surface supérieure des composants horlogers (90).

4. Procédé selon l'une des revendications précédentes, dans lequel l'oxydation thermique de la plaquette SOI (10) à l'étape (b) est réalisée à une température comprise entre 800°C et 1200°C et dans une atmosphère oxydante.

5. Procédé selon l'une des revendications précédentes, dans lequel la couche d'oxyde (55) formée sur les surfaces flancs (95) des composants horlogers (90) a une épaisseur d'au moins 0.05 µm.

6. Procédé selon l'une des revendications précédentes, le procédé comprenant également une étape de formation de trous de libération (34) dans la couche de travail (30).

7. Procédé selon l'une des revendications précédentes, le procédé comprenant également une étape de formation d'une tranchée de libération (32) dans la couche de travail (30), la tranchée de libération (32) définissant un périmètre de la partie (30A) de la couche de travail (30) qui sera libérée.

8. Procédé selon l'une des revendications précédentes, dans lequel l'étape (c) est réalisée par une gravure par voie humide ou en phase vapeur à base d'acide fluorhydrique (HF).

9. Composant horloger (90) en silicium réalisé par un procédé de fabrication selon l'une des revendications 1 à 8.

10. Piece d'horlogerie comprenant un composant horloger (90) selon la revendication 9.
